# EUROPEAN PATENT SPECIFICATION

(11) **EP 3 874 534 B1**
(45) Date of publication and mention of the grant of the patent: **22.11.2023**
(21) Application number: 19779747.5
(22) Date of filing: 24.09.2019
(51) Int. Cl.: H01H 9/16, H01H 9/18, G01R 31/67, H01H 71/04

(54) **ELECTRICAL INSTALLATION SYSTEM**
ELEKTRISCHES INSTALLATIONSSYSTEM
SYSTÈME D'INSTALLATION ÉLECTRIQUE

(30) Priority: 30.10.2018 DK PA201800786
(43) Date of publication of application: 08.09.2021
(73) Proprietor: Easy Detector Aps, 1302 København K (DK)
(72) Inventor: ARNDAL, Allan Krause, 1302 København K (DK)
(74) Representative: Patentgruppen A/S
(86) International application number: PCT/DK2019/050283
(87) International publication number: WO 2020/088721

(56) References cited:
- US-A- 6 163 144
- US-A1- 2013 313 088
- US-A1- 2016 211 101

## Description

### Field of the invention

The present invention relates to an electrical installation system offering a safe and fast indication of which of the protection devices in a distribution board, such as fuses, circuit breakers or residual current devices, correspond to a particular circuit in an electrical installation.

### Background of the invention

Electrical installations are often based on a central distribution board connected to an external electrical source, and defining two or more local electrical circuits which are individually interruptible by switches, fuses, circuit breakers, residual current devices, or combinations or alternatives thereof. Some circuits may have one phase, and other circuits can have several phases, e.g. three phases. A number of electrical sockets, lamp outlets, electrical consumers or connections for consumers, are typically part of each circuit, so that an interruption at the distribution board of a particular circuit also interrupts power distribution to all the sockets, outlets, etc., of that particular circuit, but not of the other circuits, due to the individual protection and interruptibility.

The distribution and location of the individual electrical circuits throughout the building is often incomprehensible and hard to follow because the cables run inside walls or cable trays, and each circuit may further branch out in several different routes. Typically, it is not possible to determine from a particular socket or electrical consumer, which of the circuits it is connected to. Often the professional who sets up a new electrical installation attempts to mark the individual circuits at the distribution board with labels such as "Lights 1", "Lights 2", "Server room 1", "Server room 2", etc. But because the marking disappears, or the circuits get modified over the years by further branching, etc., or no-one remembers which server room was 1 and 2, respectively, the marking is usually not considered sufficiently safe to rely on for future handling of the phase carrying wires (also referred to as live or hot wires) of the circuits.

Consequently, when modification has to be made on a circuit, e.g. replacing a socket, installing a dimmer in an outlet, branching to a new socket, etc., and the electricity of that circuit therefore has to be interrupted for safety, the professional conventionally has to either interrupt all the circuits to be sure, or search for the relevant circuit breaker by trial-and-error, i.e. interrupting one circuit at a time and measuring whether voltage has disappeared from the wire that is going to be handled. Both methods result in several circuits losing their current for shorter or longer time, although no work on them is intended. For some installations, e.g. simple domestic installations, it may not be a big problem to turn everything off for half an hour, but with more time-demanding work the lack of electricity on the other circuits may become problematic. For more complex installations with timers, surveillance, WiFi routers and home automation, and in particular for industry buildings with production processes e.g. controlling chemical processes or driving machines, hospitals with electrical equipment vital for the patients, office buildings with hundreds of employees working on computers, data centres with huge amounts of servers, etc., it is crucial to not interrupt more of the electrical circuits than absolutely necessary, and not interrupt any circuits without prior notice to the users.

US 2013/0313088 A1 discloses an electrical installation system according to the preamble of independent claim 1 and further discloses circuit interrupters with indicator circuits for installation at the distribution board, and a signal transmitter to use at a remote location, e.g. at a socket. The electrician connects the signal transmitter to the socket that needs maintenance, and the signal transmitter transmits a signal on the power line, with a signal frequency substantially greater than the power line frequency. The indicator circuits comprise filters to block the power line frequency but pass the signal frequency, so that the indicator circuit of only the same circuit as the socket being signalled from, lights up. A disadvantage of this solution is that the electrician has to bring a signal transmitter compatible with the indicator circuits installed in the circuit interrupters each time work on the installation is required. If another electrician is going to work on the installation, they may not have access to the same signal transmitter. A further disadvantage is that the signal from the transmitter is vulnerable to electrical noise, which may reduce the reliability by causing false indications as noise may pass through the filter and turn on the indicator even when no signal is present and by causing false non-indications as the noise may modify the signal so it does not pass through the filter. Further disadvantages are related to the requirement of the transmitter being plugged into a socket with no safe and easy alternative for testing at non-socket locations or with sockets of different types, and the complex superposed signal may not be readily measurable for doublecheck or in case the indicator light is broken.

### Summary of the invention

The inventor has identified the above-mentioned problems and challenges related to determining the correct circuit breaker for interrupting a specific circuit in a fast and safe way, while avoiding unnecessary interruption of other circuits. The inventor has subsequently made the below-described invention which may improve working safety for the professional, reduce annoyance and critical outages for the users, and achieve faster and/or more reliable detection of the relevant circuit breaker with consequently reduced costs for future work on electrical installations that have the present invention included.

In an aspect, the invention relates to an electrical installation system comprising a circuit interrupter, an electrical connection point such as a socket, and a power cable electrically connecting the circuit interrupter and the electrical connection point. The circuit interrupter comprises a responder such as an indicator light or sounding body. The electrical connection point comprises a responder terminal. The power cable comprises a responder wire connecting the responder of the circuit interrupter with the responder terminal of the electrical connection point. The electrical installation system is configured to activate the responder when electrical contact is made between the responder terminal and a phase carrying wire of the electrical connection point.

The electrical installation system of the present invention ensures an unambiguous relationship to be established between the circuit interrupters in the distribution board and the electrical connection points located remotely along the different electrical circuits.

For example, in a building with several circuit interrupters and thereby several electrical circuits, e.g. tens of circuits, with missing or unreliable marking and no clear-cut distribution of circuits throughout the building, the present invention allows the professional to determine a relationship between a particular electrical connection point somewhere in the building and the related circuit interrupter in the distribution board, in a safe, fast and reliable way, which does not require shutting off irrelevant circuits and thereby create critical outages or annoyance.

When the system of the present invention is installed, the benefits are available immediately and for all future maintenance on the installation, thereby decreasing future costs because of reduced hours for the professional and avoidance of unnecessary outages.

The safety for the professional is increased because reliable relationships to the circuit interrupters can be determined, thereby reducing the need to either annoy all users or take an unsafe chance of guessing.

As the present invention does not rely on superimposed signals no advanced equipment is required, it is more robust against electrical noise and it is simpler to troubleshoot.

The invention applies to any electrical installation system built with a number of circuit breakers and circuit layouts that are not immediately comprehensible, e.g. using hidden wiring. The electrical systems may for example be domestic, commercial or industrial systems, and be single phase 230V AC / 120V AC systems primarily for lighting and power sockets for consumer devices, as well as three phase or split phase 400V AC / 240V AC systems for high-power appliances.

The present invention is particularly advantageous for electrical installations with increased security and reliability requirements, such as for example in industry, hospitals, pharmaceutical companies, airports, ships, hotels, data centres and server rooms, and generally for installations where it may be fatal to trip the wrong circuit breaker and thereby interrupt a circuit unintentionally and without prior notice.

Conventional electrical installations are built by running a cable from a circuit breaker or residual current device of the distribution board to a socket or outlet. Normally, a 230V wiring requires a 3-wire cable having a phase carrying wire, a neutral wire and a protective earth wire. According to an embodiment of the invention, an additional wire is required between the circuit breaker and the socket, preferably as part of the cable, and the additional wire is attached to a separate responder terminal in a socket having 4 terminals instead of the conventional 3 terminals. The responder terminal may be used to detect the related circuit breaker in the distribution board. The detection may according to an embodiment be made by removing a front plate from the socket, and establish a connection between the phase carrying wire and the additional wire in the cable. The connection may be established by activating a switch, for example a toggle switch being part of the socket, a screw which may be fastened to create connection, or an isolated pin or sheet metal configured to be pushed into contact. In the distribution board the related fuses, miniature circuit breaker, residual circuit device or residual circuit breaker with over-current protection, and is in extension of the device mounted with a responder, for example a light emitting diode or indication lamp. The responder may for example be a light emitting diode integrated in a circuit breaker, to which the additional, fourth wire is also attached. The light emitting diode may light up or flash to indicate the specific circuit breaker which is connected to the socket, when the connection between the phase and the additional wire is established at the socket. Thereby a safe, fast and correct interruption of the circuit can be made. Similar features can be added to CEE 17 sockets (400V) or safety switches. Further, an embodiment of the invention provides a new type of circuit breaker comprising an integrated light emitting diode for detection. In the circuit breaker, a fixed connection to neutral is made from the light emitting diode or indication lamp, and the additional wire of the cable is attached to a terminal connected to this light emitting diode. Thereby the light emitting diode turns on when the toggle switch is closes, the screw is fastened or the isolated pin makes connection in the 230V or 400V installation, whereby detection and location of relationship between circuit breaker and switch is achieved.

In an embodiment, the responder terminal is connected to the phase carrying wire via a responder switch configured to establish the electrical contact when activated. In an embodiment, the responder is connected between a neutral wire and the responder wire.

By operating the responder switch, it is thereby possible, at the remote location of the electrical connection point, e.g. a socket somewhere in the building, to connect a phase to the responder wire, which in other words connects the phase to the responder, whereby the responder may be activated, e.g. emit light. As the responder is part of the circuit interrupter, it is thereby readily indicated which circuit interrupter controls the circuit to which the remote socket or other connection point belongs. Preferably the responder has two terminals, and the one not connected to the responder wire and indirectly connectable to a phase, is preferably connected to a neutral wire in order to facilitate a circuit through the responder for its activation. The neutral wire may be from the circuit itself, thereby interruptible by the circuit interrupter together with the phases, or be from outside the circuit, preferably from the inlet to the circuit interrupter to allow the responder to function even with an interrupted circuit.

In an embodiment, the responder is configured to perform one or more of the following when activated: emit light, flash, vibrate or emit sound.

The responder may for example be a simple light bulb, which lights up when a phase is connected, or it may be a more complex light source for example based on light emitting diode LED technology, and including an appropriate driver to transform the AC phase to a suitable power form for the light source, optionally also controlling a flashing scheme or the like. In other embodiments, the responder may comprise a vibrator, e.g. small electromotor, or a sound emitter, e.g. a buzzer, loudspeaker, etc. The responder may also include a display to indicate a circuit number, a circuit name, etc.

In an embodiment, the power cable comprises at least the responder wire, a neutral wire and one or more phase carrying wires, and optionally further comprises a protective earth wire and/or one or more switch wires; and/or wherein the power cable is a collection of wires preferably run in a common jacket or common conduit.

A 4-wire cable is preferred for the present invention in typical single phase circuits, as a neutral wire, a phase carrying wire and a protective earth wire are usually required. By using a 5- og 6-wire cable, there will further be provided one or two switch wires for use in lighting control. In three-phase circuits, a 6-wire cable is preferred, i.e. the 4-wire cable with two additional phase carrying wires. According to the present invention, the term power cable denotes a collection of wires run together, including a phase carrying wire, but does not require that they are provided as a single multi-core cable with a common jacket. The 6-wire power cable may for example comprise two 3-wire cables, or plastic conduits in which 6 individual wires are run, or a conventional 3- or 5-wire cable and an additional individual responder wire run besides it to achieve a total of 4 or 6 wires. The wires may be stranded or solid according to local electricity wiring regulations. If local regulations allow, the responder wire may be thinner than the other wires as the responder preferably only consumes very little current.

In an embodiment, the responder switch is from the list of a tumbler switch, a microswitch, a push button switch, a screw configured to make contact when fastened, a spring-loaded pin or sheet metal configured to be pushed into contact, a piece of bare wire configured to be movable into contact, or a narrow gap between two terminals configured to be connected by means of a conducting tool such as a screwdriver head.

In other words, any way of providing a reasonable fast and convenient way of temporarily connecting the phase to the responder wire is within the scope of the invention. By using a toggle type switch or connection, e.g. a screw or microswitch, the responder is maintained in activated mode until the switch is toggled again, thereby allowing the professional to move from the remote location of the electrical connection point to the location of the circuit interrupter to determine which for circuit interrupter a responder is activated. The same can be achieved for temporary switches such as a push button or narrow gap short-circuited by a screwdriver head, by providing a timer or delay functionality in the responder, e.g. simply by means of a capacitor quickly being charged at the temporary connection to a phase, but slowly discharging through the responder light bulb and a series-connected resistor. By using a temporary switch such as a push button or narrow gap short-circuited by a screwdriver head, without a delay functionality, a colleague or camera has to monitor the responders at the distribution board, but an advantage is that the responder is automatically disconnected when releasing the button. The responder may also have an activate-and-hold functionality, requiring a reset at the responder location to turn the indication off. Such functionality requiring additional power than provided by the temporary connection to the responder wire, requires that the responder has access to a permanent phase, a low-voltage power supply or a battery. With an activate-and-hold functionality that is powered even when the related circuit interrupter has interrupted the circuit, the responder may stay activated throughout the work session, thereby indicating that work is being performed on the circuit and serve as a warning not to toggle the circuit interrupter on. In an embodiment, the circuit interrupter and responder is arranged so it cannot be turned on as long as the responder is activated.

In an embodiment, the circuit interrupter is configured to interrupt at least one phase carrying wire and a neutral wire in case of over current and/or residual current in the circuit; and/or wherein the circuit interrupter is from the list of a fuse, a circuit breaker, a miniature circuit breaker MCB, a residual-current device RCD, a residual-current circuit breaker with overcurrent protection RCBO, a ground fault circuit interrupter GFCI, a ground fault interrupter GFI, or an appliance leakage current interrupter ALCI.

The circuit interrupter may be any device allowing manual interruption of an electrical circuit, but is preferably one of the circuit interruption devices anyway required by local regulation, such as for example fuses or circuit breakers to break circuits at an over-current condition, and/or residual-current devices to break circuit at a residual-current condition, e.g. when a phase gets connected to protective earth through a damaged device, or to ground through for example a person touching a leaking appliance or bare wire. Combination circuit breakers offering both kinds of protection are also preferred circuit interrupters according to the invention. Other circuit interrupters with similar applications as the list above are also considered within the scope of the invention. Typically, the circuit interrupters mentioned here, besides their automatic protective interruption functionality, provides a manually operated switch to allow the professional to break the circuit when the correction circuit interrupter has been determined. Usually, modern circuit interrupters are designed to interrupt all phases and neutral of a circuit simultaneously, but any interruption scheme is within the scope of the invention.

In an embodiment, the electrical connection point comprising the responder terminal is from the list of a one-phase socket, a three-phase socket, a split-phase socket, a lighting switch, a safety switch, a junction box, a ceiling rose, a light outlet, a light fitting or an industrial socket.

The electrical connection point may be any location at an electrical circuit where maintenance or modification may be relevant in the future, and it will thereby be necessary to determine the correct circuit interrupter to break the circuit before starting the work. Typically, such electrical connection points are from the list above, i.e. various kinds of sockets, junctions, switches, etc., which may either be relevant to replace in the future, or serve as starting point for a new branching of the circuit. Often such electrical connection points are easy and fast for the professional to open to reveal the wiring and/or the responder switch, and may thereby allow easy and fast access to the responder switch while still hiding it from the everyday user.

In an embodiment, the electrical installation system is a 230V AC system, a 400V AC system, a 230/400V AC system, or a 110-120V AC system.

In other words, the present invention is applicable in electrical systems based on EU regulation, US regulation or any similar systems.

In an aspect, the invention relates to a circuit selection method for selecting a circuit interrupter in a distribution board comprising two or more circuit interrupters each defining an electrical circuit having at least a neutral wire, a phase carrying wire and a responder wire different from the phase carrying wire, wherein the circuit interrupters each comprises a responder, such as an indicator light or sounding body, connected to the responder wire of the respective electrical circuit. The method comprises establishing connection between the responder wire and the phase carrying wire of a particular one of the electrical circuits remote from the distribution board; activating the responder, such as turning on a light or a sound, connected to the responder wire of the particular one of the electrical circuits; and selecting that circuit interrupter among the two or more circuit interrupters of the distribution board which comprises the activated responder.

By the present method, a professional may fast, safely and easily determine which circuit interrupter is related to a specific circuit of interest, and thereby be able to interrupt that specific circuit without interrupting the other circuits. The method may preferably comprise establishing the connection between the responder wire and the phase carrying wire by means of a responder switch at an electrical connection point of the circuit such as a socket, junction or switch. The method is may advantageously be carried out in an electrical installation system according to any of the above-described.

### The drawings

Various embodiments of the invention will in the following be described with reference to the drawings where
fig. 1 illustrates an embodiment of a distribution board according to the invention, as part of an electrical installation system according to an embodiment of the invention,
fig. 2 illustrates an embodiment of several electrical circuits according to the invention, as part of an electrical installation system according to an embodiment of the invention,
fig. 3 illustrates an embodiment of an electrical installation system of the present invention comprising a distribution board with a residual-current circuit breaker with overcurrent protection RCBO, and
fig. 4 illustrates an embodiment of an electrical installation system of the present invention comprising a distribution board with a miniature circuit breaker MCB.

### Detailed description

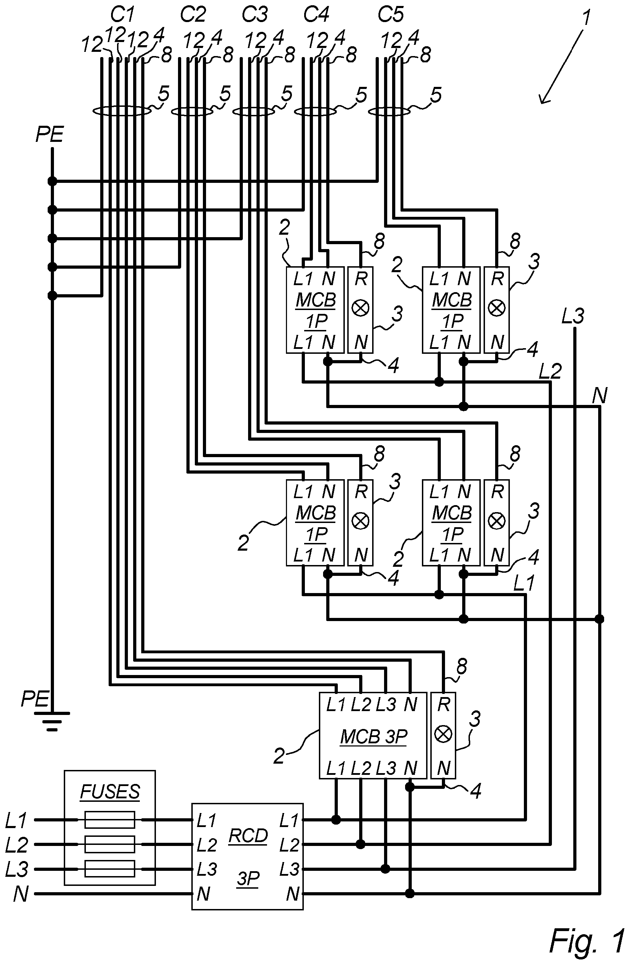

Fig. 1 illustrates an embodiment of a distribution board 1 according to the invention, as part of an electrical installation system according to an embodiment of the invention. The distribution board 1 receives a power feed with 3 phases L1, L2, L3 and neutral N at the lower left corner through a set of fuses. The power feed is run through a 3-phase residual current device RCD to achieve residual currents protection for the users and appliances. The phases and neutral is then connected to several circuit interrupters 2, in this case a single 3-phase miniature circuit breaker MCB and four single-phase miniature breakers MCB.

Each of the five circuit interrupters 2 comprises a responder 3 according to the invention. The responder may be an integral part of the circuit interrupters, e.g. an integral part of circuit breakers and/or residual current devices or combinations thereof or other circuit interrupters, or the responders 3 may be separate devices installed next to each circuit interrupter 2. The latter may for example be advantageous for retrofitting in existing distribution boards, or when installing a distribution board using conventional circuit interrupters not having integrated responders.

Each of the five circuit interrupters 2 defines an electrical circuit C1-C5, respectively. The electrical circuits are distributed throughout the building by power cables 5, comprising at least one phase carrying wire 12 and the neutral wire 4 in order to power appliances and lighting connected to the circuits. In the example of Fig. 1, electrical circuit C1 comprises 3 phase carrying wires, and the other circuits C2-C5 comprise only a single phase carrying wire, each. Circuits C2-C3 are connected to he first phase L1, and the circuits C4-C5 are connected to the second phase L2. Only the three-phase circuit C1 is using the third phase L3 according to the drawing for the sake of simplicity. Distribution boards in complex houses, commercial and industrial buildings, etc., typically defines considerably more circuits than illustrated.

Preferably, all circuits C1-C5 also comprise a wire connected to protective earth PE, as illustrated.

The responders 3 are each connected to the neutral wire 4 on the external side of the circuit interrupter 2 but may alternatively be connected to neutral on the internal side, i.e. the circuit side, of the circuit interrupter 2.

The responders 3 are also connected to the end of a responder wire 8 on the internal side, i.e. the circuit side. The responder wire 8 for each circuit C1-C5 is also included in the power cables 5 for each circuit.

Thereby, a single-phase circuit C2-C5 preferably comprises at least 4 wires, and a three-phase circuit C1 preferably comprises at least 6 wires.

The responders 3 are shown to each comprise a light source. Alternatively or in addition, they may comprise other attention means such as sound sources, vibrators, etc. The light source or other attention means is preferably a low-power means, e.g. a light emitting diode LED-based light source with appropriate driver means for being powered from a phase wire of the system.

Activation of a responder 3 is done by connecting a phase to the responder wire 8, which will cause the light source or other attention means of the responder 3 to activate, as the responder wire 8 is connected to a neutral wire 4 through the responder 3. As the responders 3 are individually activatable by their individual responder wires 8, the connection of a phase to a responder wire 8 will cause only the related responder 3 to activate, and thereby establish an indication of a related circuit interrupter 2.

The responders 3 may include further functionality, for example a timer or delay functionality, e.g. simply a capacitor quickly being charged at the temporary connection of the responder wire to a phase, but slowly discharging through the responder light source and a series-connected resistor. Thereby the indication may last sufficiently long for the professional having activated the responder 3 from somewhere in the building, to walk to the distribution board 1 to watch the indication and select the appropriate circuit interrupter 2. The indication may be turned off by allowing the time to discharge, or by providing a reset functionality to discharge the capacitor immediately. The responder may also have an activate-and-hold functionality, requiring a reset at the responder location to turn the indication off. Such functionality requiring additional power than provided by the temporary connection to the responder wire, requires that the responder has access to a permanent phase, a low-voltage power supply or a battery. With an activate-and-hold functionality that is powered even when the related circuit interrupter 2 has interrupted the circuit, the responder may stay activated throughout the work session, thereby indicating that work is being performed on the circuit and serve as a warning not to toggle the circuit interrupter on. In an embodiment, the circuit interrupter and responder is arranged so it cannot be turned on as long as the responder is activated.

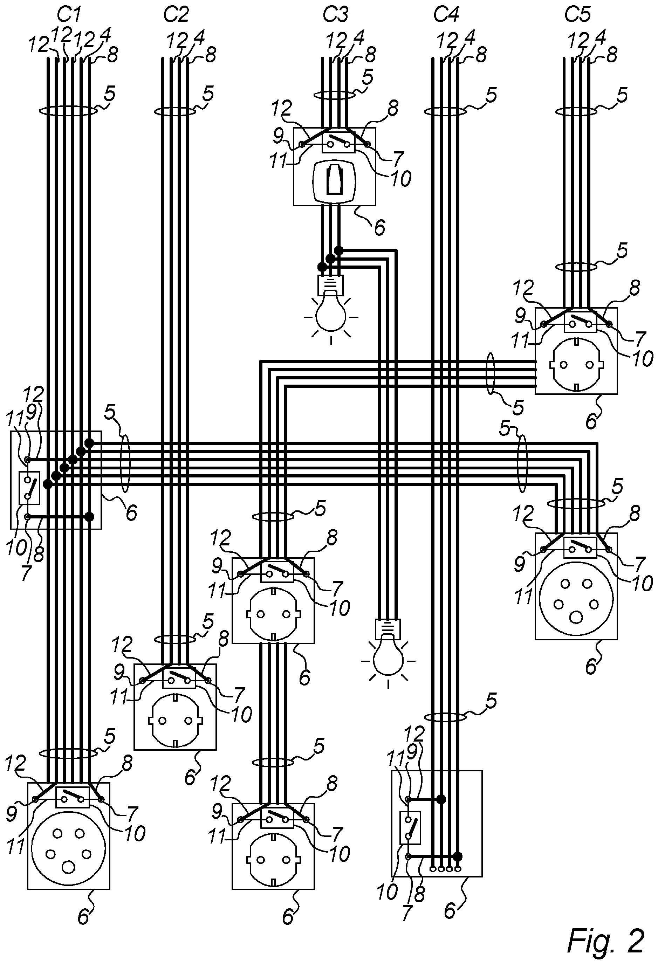

Fig. 2 illustrates an embodiment of several electrical circuits C1-C5 according to the invention, as part of an electrical installation system according to an embodiment of the invention. The electrical circuits C1-C5 illustrated may for example be the circuits defined by the distribution board 1 of Fig. 1 as described above.

The first circuit C1 is a three-phase circuit and comprises an electrical connection point 6 in the form of a junction box, where the circuit branches out to two three-phase sockets or outlets, for example IEC 6039-sockets, also referred to as CEE 17 sockets. The outlets comprising the sockets are also electrical connection points 6.

The second circuit C2 is a single-phase circuit and comprises in this simplified drawing only a single socket of the CEE 7/3 type, also referred to as a Schuko socket. The outlet comprising the socket is an electrical connection point 6.

The third example circuit C3 is a single-phase circuit and comprises a wall-mounted lighting switch, also establishing an electrical connection point 6 according to the invention. The lighting switch is controlling the power to two light fittings. The light fitting are in this example only connected by three wires, i.e. a phase carrying wire or switch wire, a neutral wire and a protective earth wire.

The fourth example circuit C4 is a single-phase circuit which is not yet put into service, and simply ends in a junction box being an electrical connection point 6 according to the invention, for example being ready to serve as electrical circuit for a future expansion of the building.

The fifth example circuit C5 is a single-phase circuit comprising three electrical connection points 6 in the form of sockets of the CEE 7/3 type, also referred to as Schuko sockets.

As can readily be seen from Fig. 2, even the few simple circuits C1-C5 with only a few consumers and electrical connections points 6 each, the circuit layout quickly gets complex, and when preparing to replace or otherwise work on for example one of the Schuko sockets, it is not easy to reliably and with complete certainty determine which circuit breaker 2 from Fig. 1 should be switched off, if the only information comes from circuit breaker markings and the general building room layout. These difficulty and safety issues even multiply considerably in real life installations with many more circuits, consumers and electrical connection points, and typically with no up-to-date drawing like Fig. 2 available.

In an embodiment of the invention, all the circuits C1-C5 in the example therefore has included in all the power cables 5 that run to the electrical connection points 6 a responder wire 8, also when looping the power cable 5 on to the next electrical connection point 6, as for example seen in the fifth circuit C5. However, as for example seen in the third circuit C3, the responder wire 8 is not looped on to the light fittings in this example. In various embodiments, the responder wire 8 may be included with all cables in the installation, or only some cables according to practicality, costs and consideration of potential future maintenance on the installation.

Further, some or all of the electrical connection points 6 comprise means to activate the responder 3 of the connected circuit interrupter 2 (Fig. 1). For example, the Schuko socket of the second circuit C2 comprises a responder terminal 7 connected to the responder wire 8 of the power cable 5. A responder switch 10 is further provided to allow establishment of electrical contact 11 from the responder terminal 7 to a phase carrying terminal 9 connected to a phase carrying wire 12 of the power cable 5. In other words, the professional may use the responder switch 10 to connect a phase to the responder wire 8, which is connected to the responder 3 (Fig. 1), to activate the responder 3 and thereby indicate which circuit interrupter 2 is related to the second circuit C2.

Similar responder switches 10 and responder terminals 7 to establish electrical contacts 11 to phase carrying terminals 9 are provided in the other electrical connection points 6 of the embodiment of Fig. 2. Thereby the professional, from the location of any of the electrical connection points 6, may activate an indication at the location of the distribution board 1 of the respective related circuit interrupter 2 by means of the responders 3. With three-phase circuits such as the first circuit C1, the invention works with the electrical connection 11 being made to any of the three phases.

The responder switches 10, electrical connections 11 and terminals 7 and 9 of Fig. 2 are merely shown as block diagrams. Various implementations are possible, and the implementation may be different for different kinds of electrical connection points, product lines, manufacturers, etc. In principle, any means for allowing temporary contact to be made between a phase 12 and the responder wire 8 is within the scope of the invention. Preferred embodiments provide a safe and user-friendly switch mechanism for this purpose, such as a microswitch, a push button, a screw making contact when fastened, etc. The responder switch 10 may preferably be located inside an enclosure to be hidden until a front plate is removed, a wall box is opened, etc. The responder switch 10 and the responder terminal 7 may preferably be integrated in a socket unit, wall switch unit, safety switch unit, junction box unit, etc., whereby the accessibility, safety and usability for the professional may typically be high. In alternative embodiments the responder switch 10 and the responder terminal 7 may be a separate unit accommodated within or behind such units, e.g. a separate microswitch with one of its terminals serving as responder terminal 7 and the other being connected by a short extension wire serving as electrical connection 11 to a phase carrying terminal of the, say, socket unit it is mounted together with. Embodiments with separate responder switch 10 is advantageous for retrofitting the responder system of the invention to existing installations or for use with conventional socket units, etc., not having integrated responder terminal 7 and responder switch 10.

The responder switch 10 should be turned off after use, in order to deactivate the responder 3 in the distribution board 1. To ensure this, switch types that automatically return to open mode are preferred, e.g. push buttons, microswitches, etc. To allow the responder to be activated long enough for the professional to walk to the distribution board to monitor the indication, the responder 3 may comprise a timer or delay circuit as described above. Alternatively, such timer or delay circuitry may be provided in relation to the responder switch 10, either as a mechanical feature of the switch mechanism, or electronically, e.g. by means of a capacitor arranged to charge fast and discharge slowly as described above.

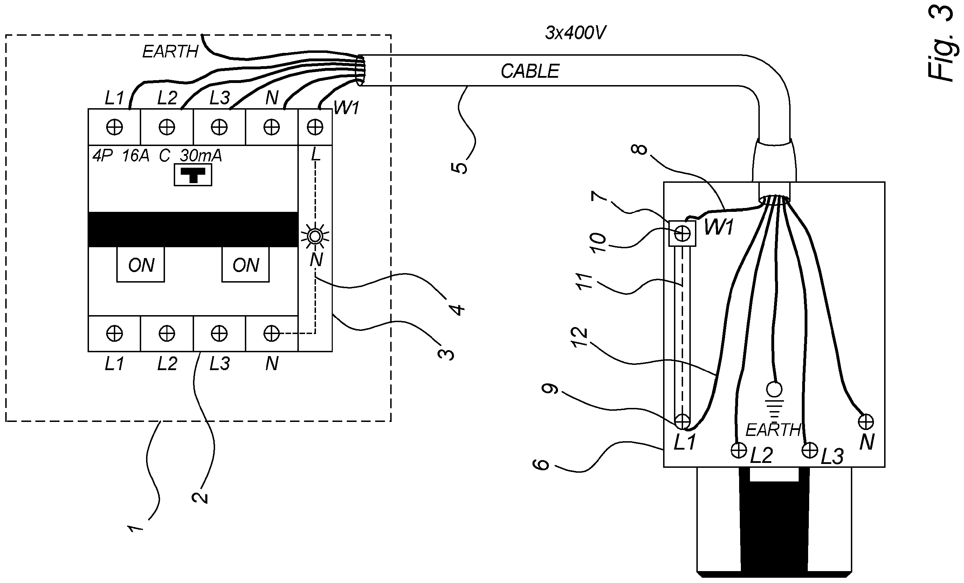

Fig. 3 illustrates an embodiment of a 400V electrical installation system of the present invention comprising a distribution board 1 with a residual-current circuit breaker with overcurrent protection RCBO 2. The RCBO 2 has an integrated indication light 3. The indication light 3 is provided with a fixed connection on the neutral terminal 4 between the RCBO 2 and the indication light 3. A cable 5 runs from the RCBO to a 400V CEE 17 socket 6 which has an additional integrated terminal 7. The cable 5 includes an additional wire W 1, 8. This additional wire 8 is connected to the indication light 3 and the additional terminal 7 in the socket 6. In order to turn on the indication light 3, a connection must be established between a phase carrying terminal L1, 9, in the socket 6 and the additional wire 8 in the cable 5. This is achieved by removing a front plate on the socket 6 and by means of a toggle switch, screw or pin 10 create an electrical connection 11 between the phase and the additional wire 8 in the cable. In the socket 6, an electrical connection 11 is provided between the phase carrying terminal L1, 9, and the additional terminal 7. This connection closes the connection from a phase carrying wire 12 through the additional terminal 7 and through the additional wire 8, which thereby makes the indication light 3 turn on. The relationship between the CEE 17 socket 6 and the correct RCBO 2 is thereby detected, and the power in the socket 6 can be turned off by deactivating the detected RCBO 2.

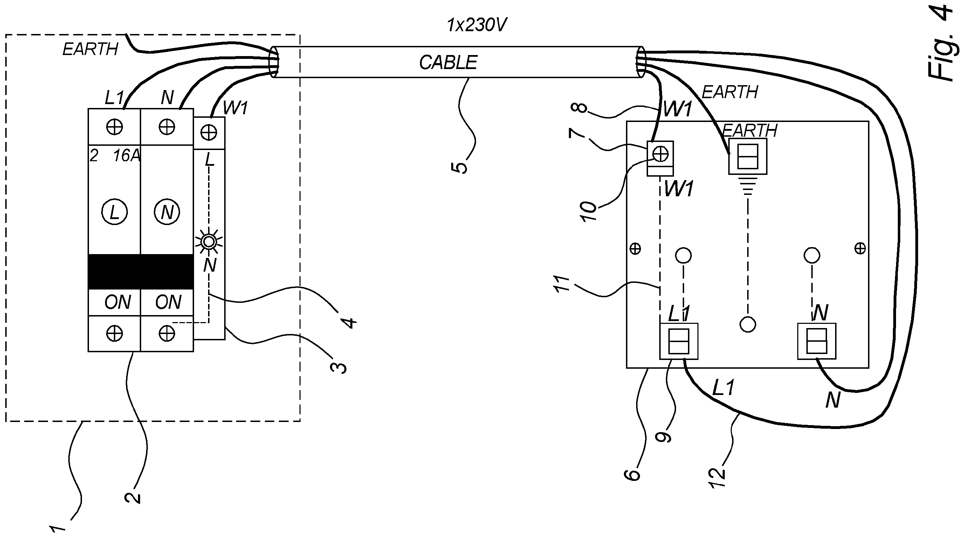

Fig. 4 illustrates an embodiment of a 230V electrical installation system of the present invention comprising a distribution board 1 with a miniature circuit breaker MCB 2. On the MCB 2 is integrated an indication light 3. In the indication light 3 is a fixed connection on the neutral terminal 4 between the MCB 2 and the indication light 3. From the MCB 2 runs a cable 5 to a 230V socket 6 with an integrated additional terminal 7. The cable 5 includes an additional wire W 1, 8. This additional wire 8 is connected to the indication light 3 and the additional terminal 7 in the socket 6. To make the indicator light 3 turn on, an electrical connection has to be established between the phase carrying terminal 9 in the socket 6 and the additional wire 8 in the cable 5. This may be achieved by removing the front plate of the socket 6, and by means of a toggle switch, screw or pin 10 create an electrical connection 11 between the phase and the additional wire 8 in the cable. The socket 6 has a connection 11 between the terminal L1, 9, and the additional terminal 7. This connection closes the connection from the phase carrying wire 12 through the additional terminal 7 and the additional wire 8, which thereby causes the indication light 3 to turn on. The socket 6 is thereby detected with the correct MCB 2, and the power to the socket 6 can be turned off by deactivating the detected MCB 2.

### List of reference signs:

- 1: Distribution board
- 2: Circuit interrupter, such as an MCB, RCD or RCBO
- 3: Responder
- 4: Neutral wire, also referred to as N
- 5: Power cable
- 6: Electrical connection point, such as a socket
- 7: Responder terminal
- 8: Responder wire
- 9: Phase carrying terminal, also referred to as L, L1, L2, L3
- 10: Responder switch
- 11: Electrical contact
- 12: Phase carrying wire, also referred to as L, L1, L2, L3
- C1-C5: Electrical circuits defined by circuit interrupters

## Claims

1. An electrical installation system comprising a circuit interrupter (2), an electrical connection point (6) such as a socket, and a power cable (5) electrically connecting the circuit interrupter (2) and the electrical connection point (6);
wherein the circuit interrupter (2) comprises a responder (3) such as an indicator light or sounding body;
**characterized in that**
the electrical connection point (6) comprises a responder terminal (7):
and **in that** the power cable (5) comprises a responder wire (8) connecting the responder (3) of the circuit interrupter (2) with the responder terminal (7) of the electrical connection point (6); and
**in that** the electrical installation system is configured to activate the responder (3) when electrical contact (11) is made between the responder terminal (7) and a phase carrying wire (12) of the electrical connection point (6).

2. The electrical installation system of claim 1, wherein the responder terminal (7) is connected to the phase carrying wire (12) via a responder switch (10) configured to establish the electrical contact (11) when activated.

3. The electrical installation system of claim 1 or 2, wherein the responder (3) is connected between a neutral wire (4) and the responder wire (8).

4. The electrical installation system of any of claims 1-3, wherein the responder (3) is configured to perform one or more of the following when activated: emit light, flash, vibrate or emit sound.

5. The electrical installation system of any of claims 1-4, wherein the power cable (5) comprises at least the responder wire (8), a neutral wire (4) and one or more phase carrying wires (12), and optionally further comprises a protective earth wire and/or one or more switch wires; and/or wherein the power cable (5) is a collection of wires (4, 8, 12) preferably run in a common jacket or common conduit.

6. The electrical installation system of claim 2, wherein the responder switch (10) is from the list of a tumbler switch, a microswitch, a push button switch, a screw configured to make contact when fastened, a spring-loaded pin or sheet metal configured to be pushed into contact, a piece of bare wire configured to be movable into contact, or a narrow gap between two terminals configured to be connected by means of a conducting tool such as a screwdriver head.

7. The electrical installation system of any of claims 1-6, wherein the circuit interrupter (2) is configured to interrupt at least one phase carrying wire (12) and a neutral wire (4) in case of over current and/or residual current in the circuit; and/or wherein the circuit interrupter (2) is from the list of a fuse, a circuit breaker, a miniature circuit breaker MCB, a residual-current device RCD, a residual-current circuit breaker with overcurrent protection RCBO, a ground fault circuit interrupter GFCI, a ground fault interrupter GFI, or an appliance leakage current interrupter ALCI.

8. The electrical installation system of any of claims 1-7, wherein the electrical connection point (6) comprising the responder terminal (7) is from the list of a one-phase socket, a three-phase socket, a split-phase socket, a lighting switch, a safety switch, a junction box, a ceiling rose, a light outlet, a light fitting or an industrial socket.

9. The electrical installation system of any of claims 1-8, wherein the electrical installation system is a 230V AC system, a 400V AC system, a 230/400V AC system, or a 110-120V AC system.

10. A circuit selection method for selecting a circuit interrupter (2) in a distribution board (1) comprising two or more circuit interrupters (2) each defining an electrical circuit having at least a neutral wire (8), a phase carrying wire (12) and a responder wire (8) different from the phase carrying wire (12), wherein the circuit interrupters (2) each comprises a responder (3), such as an indicator light or sounding body, connected to the responder wire (8) of the respective electrical circuit; the method comprising:
establishing connection between the responder wire (8) and the phase carrying wire (12) of a particular one of the electrical circuits remote from the distribution board (1);
activating the responder (3), such as turning on a light or a sound, connected to the responder wire (8) of the particular one of the electrical circuits; and
selecting that circuit interrupter (2) among the two or more circuit interrupters of the distribution board (1) which comprises the activated responder (3).

11. The circuit selection method of claim 10, wherein the method is carried out in the electrical installation system according to any of claims 1-9.

## Patentansprüche

1. Elektrisches Installationssystem, umfassend einen Schaltungsunterbrecher (2), einen elektrischen Verbindungspunkt (6) wie eine Steckdose und ein Leistungskabel (5), das den Schaltungsunterbrecher (2) und den elektrischen Verbindungspunkt (6) elektrisch verbindet;
wobei der Schaltungsunterbrecher (2) einen Responder (3) wie eine Kontrollleuchte oder einen Schallkörper umfasst;
**dadurch gekennzeichnet, dass**
der elektrische Verbindungspunkt (6) einen Responder-Anschluss (7) umfasst;
**und dadurch, dass**
das Leistungskabel (5) einen Responder-Leiter (8) umfasst, der den Responder (3) des Schaltungsunterbrechers (2) mit dem Responder-Anschluss (7) des elektrischen Verbindungspunkts (6) verbindet; und
**dadurch, dass**
das elektrische Installationssystem konfiguriert ist, um den Responder (3) zu aktivieren, wenn der elektrische Kontakt (11) zwischen dem Responder-Anschluss (7) und einem phasentragenden Leiter (12) des elektrischen Verbindungspunkts (6) hergestellt wird.

2. Elektrisches Installationssystem nach Anspruch 1, wobei der Responder-Anschluss (7) mit dem phasentragenden Leiter (12) über einen Responder-Schalter (10) verbunden ist, der konfiguriert ist, um den elektrischen Kontakt (11) herzustellen, wenn er aktiviert ist.

3. Elektrisches Installationssystem nach Anspruch 1 oder 2, wobei der Responder (3) zwischen einem Neutralleiter (4) und dem Responder-Leiter (8) verbunden ist.

4. Elektrisches Installationssystem nach einem der Ansprüche 1 bis 3, wobei der Responder (3) konfiguriert ist, um eines oder mehrere der Folgenden durchzuführen, wenn er aktiviert ist: Emittieren von Licht, Blinken, Vibrieren oder Emittieren von Schall.

5. Elektrisches Installationssystem nach einem der Ansprüche 1 bis 4, wobei das Leistungskabel (5) mindestens den Responder-Leiter (8), einen Neutralleiter (4) und einen oder mehrere phasentragende Leiter (12) umfasst und optional ferner einen Schutzleiter und/oder einen oder mehrere Schaltleiter umfasst; und/oder wobei das Leistungskabel (5) eine Sammlung von Leitern (4, 8, 12) ist, die vorzugsweise in einem gemeinsamen Mantel oder einer gemeinsamen Leitung verlaufen.

6. Elektrisches Installationssystem nach Anspruch 2, wobei der Responder-Schalter (10) aus der Liste eines Kippschalters, eines Mikroschalters, eines Druckknopfschalters, einer Schraube, die konfiguriert ist, um beim Anziehen Kontakt herzustellen, eines federbelasteten Stifts oder eines Blechs, das konfiguriert ist, um in Kontakt gedrückt zu werden, eines Stück blanken Leiters, das konfiguriert ist, um in Kontakt bewegbar zu sein, oder eines schmalen Spalts zwischen zwei Anschlüssen, die konfiguriert sind, um mittels eines leitfähigen Werkzeugs, wie einem Schraubendreherkopf, verbunden zu werden, stammt.

7. Elektrisches Installationssystem nach einem der Ansprüche 1 bis 6, wobei der Schaltungsunterbrecher (2) konfiguriert ist, um mindestens einen phasentragenden Leiter (12) und einen Neutralleiter (4) im Falle von Überstrom und/oder Fehlerstrom in der Schaltung zu unterbrechen; und/oder wobei der Schaltungsunterbrecher (2) aus der Liste einer Sicherung, eines Trennschalters, eines Miniaturtrennschalters, MCB, einer Fehlerstromvorrichtung, RCD, eines Fehlerstromtrennschalters mit Überstromschutz, RCBO, eines Erdschlussschaltungsunterbrechers, GFCI, eines Erdschlussunterbrechers, GFI, oder eines Vorrichtungsleckstromunterbrechers, ALCI, stammt.

8. Elektrisches Installationssystem nach einem der Ansprüche 1 bis 7, wobei der elektrische Verbindungspunkt (6), umfassend den Responder-Anschluss (7), aus der Liste einer Einphasensteckdose, einer Dreiphasensteckdose, einer Teilphasensteckdose, eines Beleuchtungsschalters, eines Sicherheitsschalters, einer Anschlussdose, einer Deckenrosette, eines Lichtauslasses, eines Lichtfittings oder einer Industriesteckdose stammt.

9. Elektrisches Installationssystem nach einem der Ansprüche 1 bis 8, wobei das elektrische Installationssystem ein 230 V-Wechselstromsystem, ein 400 V-Wechselstromsystem, ein 230/400 V-Wechselstromsystem oder ein 110-120 V-Wechselstromsystem ist.

10. Schaltungsauswahlverfahren zum Auswählen eines Schaltungsunterbrechers (2) in einer Verteilungsplatte (1), umfassend zwei oder mehr Schaltungsunterbrecher (2), die jeweils eine elektrische Schaltung definieren, die mindestens einen Neutralleiter (8), einen phasentragenden Leiter (12) und einen Responder-Leiter (8), der sich von dem phasentragenden Leiter (12) unterscheidet, aufweist, wobei die Schaltungsunterbrecher (2) jeweils einen Responder (3), wie eine Kontrollleuchte oder einen Schallkörper, umfassen, die mit dem Responder-Leiter (8) der jeweiligen elektrischen Schaltung verbunden sind; das Verfahren umfassend:
Herstellen einer Verbindung zwischen dem Responder-Leiter (8) und dem phasentragenden Leiter (12) einer bestimmten der elektrischen Schaltungen, die von der Verteilungsplatte (1) entfernt sind;
Aktivieren des Responders (3), wie beispielsweise Einschalten eines Lichts oder eines Schalls, der mit dem Responder-Leiter (8) der jeweiligen der elektrischen Schaltungen verbunden ist; und
Auswählen des Schaltungsunterbrechers (2) unter den zwei oder mehr Schaltungsunterbrechern der Verteilungsplatte (1), die den aktivierten Responder (3) umfasst.

11. Schaltungsauswahlverfahren nach Anspruch 10, wobei das Verfahren in dem elektrischen Installationssystem nach einem der Ansprüche 1 bis 9 durchgeführt wird.

## Revendications

1. Système d'installation électrique comprenant un interrupteur de circuit (2), un point de connexion électrique (6) tel qu'une prise, et un câble d'alimentation (5) reliant électriquement l'interrupteur de circuit (2) et le point de connexion électrique (6) ;
dans lequel l'interrupteur de circuit (2) comprend un répondeur (3) tel qu'un voyant lumineux ou un corps sonore ;
**caractérisé en ce que**
le point de connexion électrique (6) comprend une borne répondeur (7) ;
et **en ce que**
le câble d'alimentation (5) comprend un fil répondeur (8) reliant le répondeur (3) de l'interrupteur de circuit (2) à la borne répondeur (7) du point de connexion électrique (6) ; et
**en ce que**
le système d'installation électrique est configuré pour activer le répondeur (3) lorsqu'un contact électrique (11) est établi entre la borne répondeur (7) et un fil porteur de phase (12) du point de connexion électrique (6).

2. Système d'installation électrique selon la revendication 1, dans lequel la borne répondeur (7) est connectée au fil porteur de phase (12) par l'intermédiaire d'un interrupteur de répondeur (10) configuré pour établir le contact électrique (11) lorsqu'il est activé.

3. Système d'installation électrique selon la revendication 1 ou 2, dans lequel le répondeur (3) est connecté entre un fil neutre (4) et le fil répondeur (8).

4. Système d'installation électrique selon l'une des revendications 1 à 3, dans lequel le répondeur (3) est configuré pour effectuer une ou plusieurs des opérations suivantes lorsqu'il est activé : émettre de la lumière, un flash, vibrer ou émettre un son.

5. Système d'installation électrique selon l'une des revendications 1 à 4, dans lequel le câble d'alimentation (5) comprend au moins le fil répondeur (8), un fil neutre (4) et un ou plusieurs fils porteurs de phase (12), et éventuellement comprend en outre un fil de terre de protection et/ou un ou plusieurs fils de commutation ; et/ou dans lequel le câble d'alimentation (5) est un ensemble de fils (4, 8, 12) passant de préférence dans une gaine commune ou un conduit commun.

6. Système d'installation électrique selon la revendication 2, dans lequel l'interrupteur (10) est choisi parmi un interrupteur à bascule, un micro-interrupteur, un interrupteur à bouton-poussoir, une vis conçue pour établir un contact lorsqu'elle est fixée, une broche à ressort ou une tôle conçue pour être poussée en contact, un morceau de fil nu conçu pour être mobile en contact, ou un espace étroit entre deux bornes configurées pour être connectées au moyen d'un outil conducteur tel qu'une tête de tournevis.

7. Système d'installation électrique selon l'une des revendications 1 à 6, dans lequel l'interrupteur de circuit (2) est configuré pour interrompre au moins un fil porteur de phase (12) et un fil neutre (4) en cas de surintensité et/ou de courant résiduel dans le circuit ; et/ou dans lequel l'interrupteur de circuit (2) est choisi parmi un fusible, un disjoncteur, un disjoncteur miniature MCB, un dispositif à courant résiduel RCD, un disjoncteur à courant résiduel avec protection contre les surintensités RCBO, un interrupteur de circuit de fuite à la terre GFCI, un interrupteur de fuite à la terre GFI ou un interrupteur de courant de fuite d'appareil ALCI.

8. Système d'installation électrique selon l'une des revendications 1 à 7, dans lequel le point de connexion électrique (6) comprenant la borne répondeur (7) est choisi parmi une prise monophasée, une prise triphasée, une prise à phase divisée, un interrupteur d'éclairage, un interrupteur de sécurité, une boîte de j onction, une rosace de plafond, une prise de lumière, un luminaire ou une prise industrielle.

9. Système d'installation électrique selon l'une des revendications 1 à 8, dans lequel le système d'installation électrique est un système à 230 V CA, un système à 400 V CA, un système à 230/400 V CA ou un système à 110-120 V CA.

10. Procédé de sélection de circuit pour sélectionner un interrupteur de circuit (2) dans un tableau de distribution (1) comprenant deux ou plusieurs interrupteurs de circuit (2) définissant chacun un circuit électrique ayant au moins un fil neutre (8), un fil porteur de phase (12) et un fil répondeur (8) différent du fil porteur de phase (12), dans lequel les interrupteurs de circuit (2) comprenant chacun un répondeur (3), tel qu'un voyant lumineux ou un corps sonore, connecté au fil répondeur (8) du circuit électrique respectif ; le procédé comprenant :
l'établissement d'une connexion entre le fil répondeur (8) et le fil porteur de phase (12) d'un circuit électrique particulier distant du tableau de distribution (1) ;
l'activation du répondeur (3), par exemple l'allumage d'une lumière ou un son, connecté au fil répondeur (8) d'un circuit électrique particulier ; et
la sélection de cet interrupteur de circuit (2) parmi les deux ou plusieurs interrupteurs de circuit du tableau de distribution (1) qui comprend le répondeur activé (3).

11. Procédé de sélection de circuit selon la revendication 10, dans lequel le procédé est réalisé dans un système d'installation électrique selon l'une des revendications 1 à 9.
